# EUROPEAN PATENT APPLICATION

(11) **EP 4 667 953 A1**
(43) Date of publication of application: **24.12.2025**
(21) Application number: 24845902.6
(22) Date of filing: 16.07.2024
(51) Int. Cl.: G01R 31/36, G01R 31/392, G01R 31/396, G01R 31/382, B60L 58/16

(54) **APPARATUS AND METHOD FOR MANAGING BATTERY**

(30) Priority: 26.07.2023 KR 20230097814
(71) Applicant: LG Energy Solution, Ltd., Seoul 07335 (KR)
(72) Inventor: KIM, Ji-Yeon, Daejeon 34122 (KR); KIM, Dae-Soo, Daejeon 34122 (KR); KIM, Young-Deok, Daejeon 34122 (KR); CHOI, Soon-Ju, Daejeon 34122 (KR)
(74) Representative: Goddar, Heinz J.
(86) International application number: PCT/KR2024/010201
(87) International publication number: WO 2025/023599

(57) **Abstract**

A battery management apparatus according to an embodiment of the present disclosure includes a reference information storage unit configured to store a reference profile including a reference negative electrode profile; a profile generating unit configured to generate a negative electrode profile of each of a plurality of batteries using the reference profile and a charging and discharging profile of each of the plurality of batteries; a characteristic information generating unit configured to generate a negative electrode change ratio of the negative electrode profile compared to the reference negative electrode profile for each of the plurality of batteries; a calculation processing unit configured to calculate a relative difference of the plurality of negative electrode change ratios; and a diagnosing unit configured to diagnose a state of the plurality of batteries using a calculation result of the calculation processing unit.

## Description

### TECHNICAL FIELD

This application is based on and claims priority from Korean Patent Application No. 10-2023-0097814, filed on July 26, 2023, with the Korean Intellectual Property Office, the disclosure of which is incorporated herein in its entirety by reference.

The present disclosure relates to a technology for diagnosing and managing a state of a battery, and more specifically, to a battery management apparatus and method that effectively diagnoses a defective battery by utilizing the relative contrast of a change rate of a negative electrode profile.

### BACKGROUND ART

As the demand for portable electronic products such as laptops, video cameras, and mobile phones that use electricity as a power source increases rapidly, and as mobile robots, electric bicycles, electric carts, and electric vehicles become more widely commercialized, research on high-performance secondary batteries capable of repeated charging and discharging is actively being conducted.

Commercialized secondary batteries include nickel-cadmium batteries, nickel hydride batteries, nickel-zinc batteries, and lithium secondary batteries. Among them, lithium secondary batteries have the advantage of being free to charge and discharge and having a very low self-discharge rate compared to nickel-based secondary batteries, with almost no memory effect, and also they have the characteristics of high energy density and high operating voltage, and are therefore being studied more intensively than other types of secondary batteries and are being applied more widely in actual products.

Recently, secondary batteries are widely used not only in small devices such as portable electronic devices, but also in medium and large devices such as electric vehicles and energy storage systems (ESSs).

In this case, a battery module in which a number of electrically connected secondary batteries are stored together inside a module case is mainly applied. Furthermore, in cases where high power or large capacity is required, a battery pack in which a number of such battery modules are electrically connected is also applied.

Secondary battery cells, cell assemblies, battery modules, or battery packs (hereinafter collectively referred to as 'batteries') are important factors for power efficiency and safety. Accordingly, research is also actively being conducted on BMS (Battery Management System), which monitors the electrical characteristics of the battery and performs feedback control such as charging and discharging using the monitoring results.

Unlike the method of generating energy based on fossil fuels, secondary cell-based batteries generate energy through electrochemical reactions, so there is a problem in that they cannot maintain the performance of the BOL (Beginning Of Life) state as the charging and discharging cycle progresses.

This degradation phenomenon is an inherent phenomenon that occurs as the battery is used, but it can also be affected by manufacturing defects such as process errors, impurity contamination, physical damage (cracks, etc.), and short circuits.

In this way, as the battery continues to be used (charged and discharged), its usability decreases due to capacity deterioration, output deterioration, etc., and such deterioration also acts as a risk factor in terms of safety. Therefore, in order to control the limited use of degraded batteries, determine the replacement timing, or improve the efficiency of battery reuse (or recycling), it is necessary to accurately and quickly diagnose the current battery degradation level and whether it is defective.

### DISCLOSURE

### Technical Problem

The present disclosure is designed to solve the problems of the related art, and therefore the present disclosure is directed to providing a battery management apparatus and method that may quickly and accurately diagnose and select a defective battery by using a negative electrode change ratio (ns) generated using a negative electrode profile of each of a plurality of batteries and a relative difference value between them.

The technical problems that the present disclosure seeks to solve are not limited to the problems described above, and other problems that are not mentioned will be clearly understood by those skilled in the art from the description of the disclosure described below.

### Technical Solution

A battery management apparatus according to one aspect of the present disclosure may comprise: a reference information storage unit configured to store a reference profile including a reference negative electrode profile; a profile generating unit configured to generate a negative electrode profile of each of a plurality of batteries using the reference profile and a charging and discharging profile of each of the plurality of batteries; a characteristic information generating unit configured to generate a negative electrode change ratio of the negative electrode profile compared to the reference negative electrode profile for each of the plurality of batteries; a calculation processing unit configured to calculate a relative difference of the plurality of negative electrode change ratios; and a diagnosing unit configured to diagnose a state of the plurality of batteries using a calculation result of the calculation processing unit.

The diagnosing unit may be configured to diagnose a normal battery and a defective battery among the plurality of batteries using the calculation result.

The battery management apparatus according to another aspect of the present disclosure may further comprise a management control unit configured to control charging and discharging of the defective battery to be limited.

The diagnosing unit may be configured to generate degradation rate information for at least one battery among the plurality of batteries using the calculation result.

The battery management apparatus may further comprise a management control unit configured to control at least one battery among the plurality of batteries so that charging and discharging ranges are differentially limited according to the degradation rate information.

The calculation processing unit may be configured to perform weight calculation on a difference calculation result between an average value of the plurality of negative electrode change ratios and an individual negative electrode change ratio.

The calculation processing unit may be configured to calculate a statistical deviation value of the plurality of negative electrode change ratios.

The diagnosing unit may be configured to further diagnose a degradation imbalance of the plurality of batteries using the statistical deviation value.

The characteristic information generating unit may be configured to calculate a ratio of the negative electrode profile to the reference negative electrode profile as the negative electrode change ratio.

A battery pack according to still another aspect of the present disclosure may comprise the battery management apparatus according to an aspect of the present disclosure.

A vehicle according to still another aspect of the present disclosure may comprise the battery management apparatus according to an aspect of the present disclosure.

A battery management method according to still another aspect of the present disclosure may comprise: a profile generating step of generating a negative electrode profile of each of a plurality of batteries using a reference profile and a charging and discharging profile of each of the plurality of batteries; a characteristic information generating step of generating a negative electrode change ratio of the negative electrode profile compared to a reference negative electrode profile included in the reference profile for each of the plurality of batteries; a calculation processing step of calculating a relative difference of the plurality of negative electrode change ratios; and a diagnosing step of diagnosing a state of the plurality of batteries using a calculation result of the calculation processing step.

### Advantageous Effects

According to the present disclosure, there is an advantage in that a defective battery may be quickly diagnosed from a plurality of batteries using a reference profile and the charging and discharging profile of the battery. In addition, according to the present disclosure, degradation rate information of the defective battery may be quickly and accurately provided.

In addition, since the diagnostic method by the present disclosure may be implemented through software that can be installed in BMS, etc. or a module that executes the same, it is possible to provide higher expandability.

According to one aspect of the present disclosure, since it is possible to accurately diagnose whether an object (e.g., a battery pack) applied to an actual application device (e.g., a vehicle, ESS, etc.) is degraded and/or whether degradation imbalance is present, the effectiveness of battery control and management may be improved.

In addition, in the case of the present disclosure, the efficiency of battery management processing may be further improved by differentially applying the usage restriction range of at least one battery among a plurality of batteries according to the degradation rate information.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a block diagram illustrating a detailed configuration of a battery management apparatus according to an embodiment of the present disclosure.
FIG. 2 is a flow chart illustrating a processing process according to an embodiment of the present disclosure.
FIG. 3 is a flow chart illustrating a processing process according to an embodiment of the present disclosure in which a negative electrode profile is determined.
FIG. 4 is a flow chart illustrating a processing process according to another embodiment of the present disclosure.
FIG. 5 is a diagram illustrating an example of a graph form for a charging and discharging profile of a target battery.
FIG. 6 is a diagram illustrating an example of a graph form for a negative electrode profile of a target battery.
FIG. 7 is a drawing explaining a negative electrode change ratio (ns) generated based on a negative electrode profile.
FIG. 8 is a drawing explaining a first embodiment of a negative electrode change ratio (ns) for each of a plurality of batteries.
FIG. 9 is a drawing explaining a second embodiment of a negative electrode change ratio (ns) for each of a plurality of batteries.
FIG. 10 is a drawing explaining an example of a distribution of deviation values generated using a negative electrode change ratio (ns).

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

Throughout the specification, when a portion is referred to as "comprising" or "including" any element, it means that the portion may include other elements further, without excluding other elements, unless specifically stated otherwise.

Additionally, terms such as processor described in the specification mean a unit that processes at least one function or operation, which may be implemented by hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

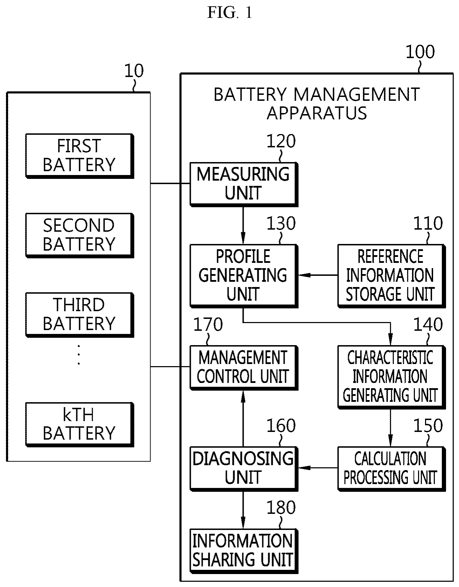

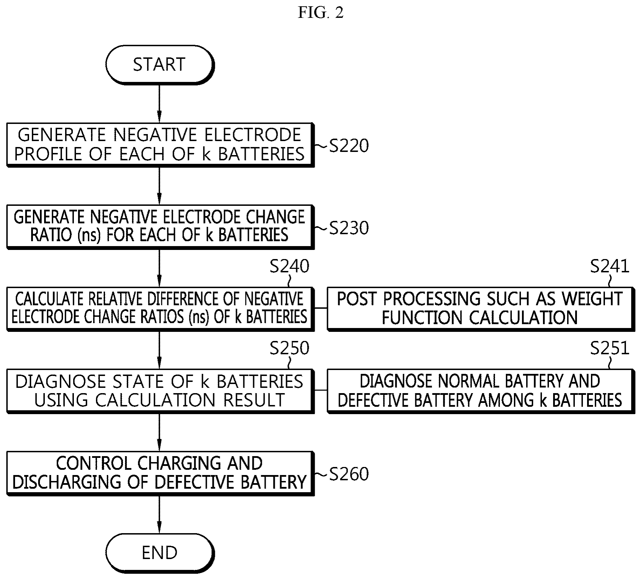

FIG. 1 is a block diagram illustrating a detailed configuration of a battery management apparatus 100 according to an embodiment of the present disclosure, and FIG. 2 is a flow chart illustrating a processing process according to an embodiment of the present disclosure.

As illustrated in FIG. 1, the battery management apparatus 100 of the present disclosure may be configured to include a reference information storage unit 110, a measuring unit 120, a profile generating unit 130, a characteristic information generating unit 140, a calculation processing unit 150, a diagnosing unit 160, a management control unit 170, and an information sharing unit 180.

Before going into the detailed description of the present disclosure, it is obvious that the battery management apparatus 100 according to the present disclosure may be implemented through various combinational applications of electronic devices, parts, etc., such as storage means, calculation processing means, input/output means, etc. Therefore, each component of the battery management apparatus 100 illustrated in FIG. 1 should be understood as a functionally or logically distinct component rather than a physically distinct component.

That is, since each component depicted in the drawing corresponds to a logical structure for effectively explaining the technical idea by the present disclosure, even if each component is configured integrated or separately, if the function performed by the logical structure of the present disclosure can be realized, it should be interpreted as being within the scope of the present disclosure, and if it is a component that performs the same or similar function, it should of course be interpreted as being within the scope of the present disclosure regardless of the consistency in their names.

In addition, the battery management method by the present disclosure may be implemented as a set or algorithm of processing for data processing, handling, control, operation, input/output, etc., and thus, it may be implemented by a combination of logical structures shown in FIG. 1, as well as in the form of software that is installed and operated in a system, device, computer (or a device equivalent thereto), BMS, module, or lower-level components thereof.

The battery management apparatus 100 of the present disclosure may be configured to detect or diagnose a normal battery and a defective battery by targeting a plurality of batteries 10. According to an embodiment, the battery management apparatus 100 may be configured to generate and output diagnostic data for a plurality of batteries 10 for organic linkage with other configurations or modules/devices.

Here, the defective battery BB refers to an abnormal battery that has a relatively high degree of degradation compared to other batteries or cannot exhibit the designed operating performance due to process errors, physical damage, etc.

From a corresponding perspective, the normal battery NB refers to a battery that has the opposite characteristics to the defective battery BB, and has driving performance (degradation level, etc.) at the same or similar level as other batteries, or a battery that implements normal driving performance (taking into account the range of errors) corresponding to the designed specifications. Here, normal driving performance does not mean driving performance of the BOL (Beginning Of Life) state, but rather driving performance that is expressed at a level of degradation within the normal range according to the number of times or degree of use while going through a normal degradation process.

For example, in the embodiment of FIG. 1, the battery management apparatus 100 may diagnose and manage a plurality of batteries 10. For example, the battery management apparatus 100 may diagnose and manage k batteries, where k is a natural number greater than or equal to 2.

Also, in FIG. 1, the plurality of batteries 10 may be a single cell or a cell assembly having a plurality of cells connected in series and/or in parallel.

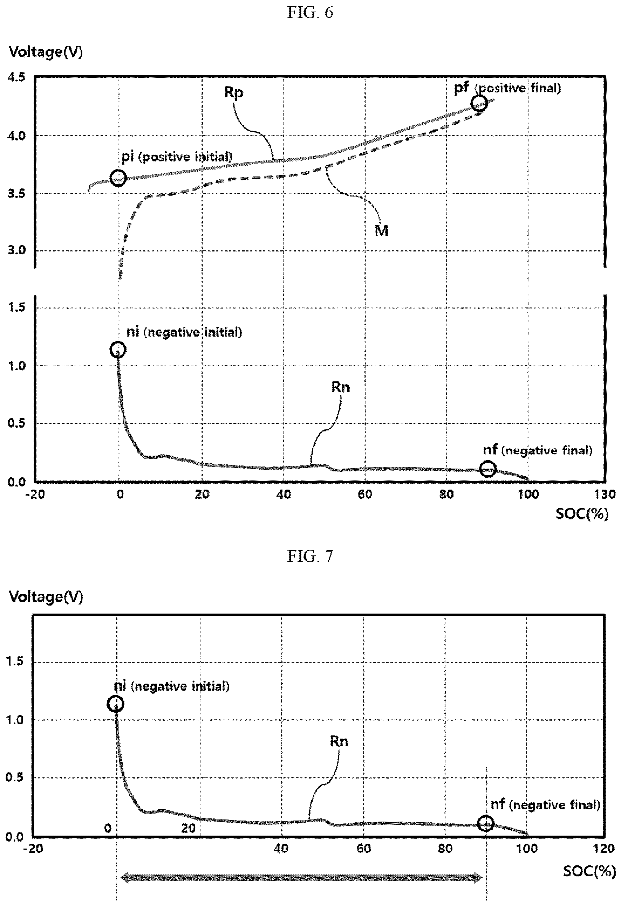

The profile generating unit 130 of the present disclosure is configured to generate a negative electrode profile (Rn, see FIG. 6, etc.) of each of the plurality of batteries 10 (S220).

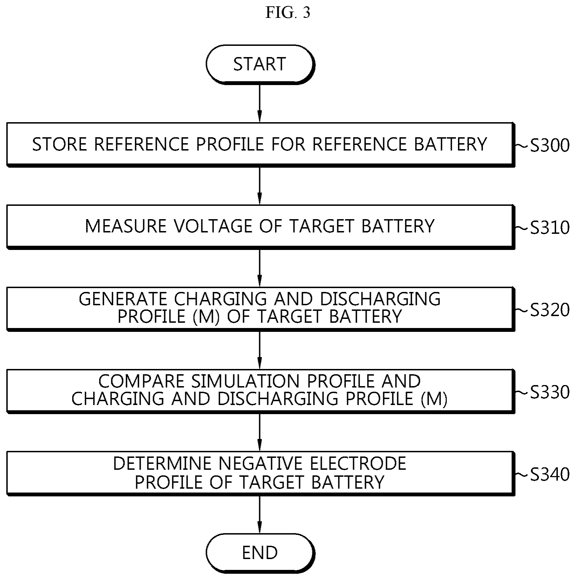

Before going into a detailed description of the specific functions and processing of the present disclosure, the process of generating the negative electrode profile Rn of each of the plurality of batteries 10 will be described briefly with reference to FIG. 3, etc.

FIG. 3 is a flow chart illustrating a processing process according to an embodiment of the present disclosure in which a negative electrode profile is determined.

The reference information storage unit 110 may be configured to store a negative electrode profile (hereinafter referred to as 'reference negative electrode profile') and a positive electrode profile (hereinafter referred to as 'reference positive electrode profile') for charging or discharging of a reference battery (S300, see FIG. 3).

The reference profile may include a reference positive electrode profile and a reference negative electrode profile. The reference profile may be a graph that can be expressed on a coordinate system in which the horizontal axis (X-axis) represents capacity (Ah) or SOC (State of charge) and the vertical axis (Y-axis) represents voltage (V), or a function or a data-set representing the same, as is known.

The reference positive electrode (negative electrode) profile may be a profile representing the positive electrode (negative electrode) voltage by capacity measured while charging or discharging a three-electrode cell or a positive electrode (negative electrode) half-cell.

Here, the reference battery is a battery having dimensions or specifications equivalent to those of the battery to be diagnosed (hereinafter referred to as the 'target battery'), and may be a battery in the BOL (Beginning Of Life) state or a simulated ideal battery for relative comparison with the target battery.

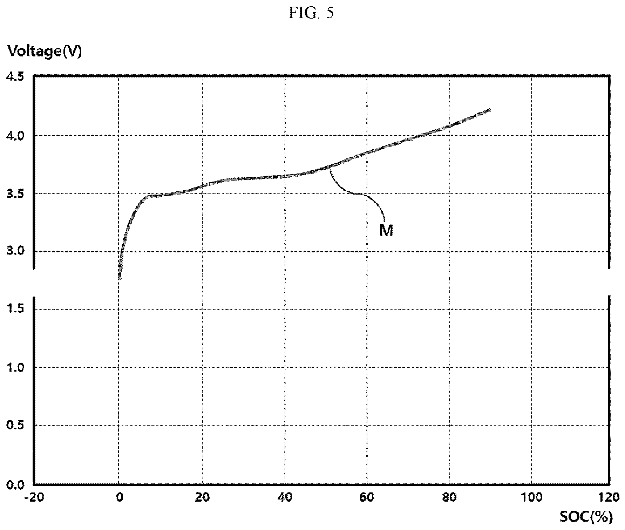

The measuring unit 120 is configured to measure electrical characteristic values (voltage, etc.) of the target battery during a charging or discharging process (S310). When the electrical characteristic values of the target battery are measured in this manner, the profile generating unit 130 of the present disclosure generates a charging and discharging profile M as illustrated in FIG. 5 by utilizing the correlation between the measured electrical characteristic values (voltage, etc.) and the capacity of the target battery (S320).

When the charging and discharging profile M is generated, the profile generating unit 130 performs processing to compare or contrast the charging and discharging profile M with a simulation profile (S330).

Here, the charging and discharging profile M is a capacity-dependent voltage profile measured from the target battery, and the simulation profile is a profile that is pre-stored or obtained from pre-stored data (reference positive electrode profile and reference negative electrode profile) for comparison with the profile of the target battery.

Therefore, the simulation profile may be stored together with the reference positive electrode (negative electrode) profile in the reference information storage unit 110.

When degradation occurs due to use (including when there is a problem in the manufacturing process), the charging and discharging profile M of the target battery changes, so a difference occurs between the simulation profile and the charging and discharging profile M.

To minimize this difference, the profile generating unit 130 may adjust the reference profile to correspond to the charging and discharging profile M. For example, the profile generating unit 130 may perform processing such as axis shift, scale adjustment, ratio adjustment, offset adjustment, and shrinkage adjustment on the reference positive electrode profile and/or the reference negative electrode profile. The profile generating unit 130 may set the adjusted positive electrode profile and the adjusted negative electrode profile through the processing, and apply fitting for the adjusted positive electrode profile and the adjusted negative electrode profile. As a fitting result, the profile generating unit 130 may obtain the positive electrode profile (Rp, see FIG. 6) and the negative electrode profile (Rn, see FIG. 6) of the target battery in which degradation, etc. is actually reflected (S340).

Specifically, factors such as pi (positive initial), pf (positive final), and ps (positive shrinkage) may be derived from the positive electrode profile Rp. Similarly, factors such as ni (negative initial), nf (negative final), and ns (negative shrinkage) may be derived from the negative electrode profile Rn.

Here, pi is the initial potential value of the positive electrode profile Rp (the positive electrode potential value of the capacity initial point of the full cell), pf is the final potential value of the positive electrode profile Rp (the positive electrode potential value of the capacity final point of the full cell), ni is the initial potential value of the negative electrode profile Rn (the negative electrode potential value of the capacity initial point of the full cell), and nf is the final potential value of the negative electrode profile Rn (the negative electrode potential value of the capacity final point of the full cell). ps is the change ratio of the positive electrode profile Rp compared to the reference positive electrode profile, and ns is the change ratio of the negative electrode profile Rn compared to the reference negative electrode profile.

The profile generating unit 130 may obtain the positive electrode profile Rp and the negative electrode profile Rn of the target battery by changing the ratio of the adjusted positive electrode profile and the adjusted negative electrode profile so that the capacity of the adjusted positive electrode profile and the adjusted negative electrode profile corresponds to the capacity of the target battery under the condition that the potential difference between pi and ni corresponds to the initial voltage of the target battery, and the potential difference between pf and nf corresponds to the final voltage of the target battery. For example, the potential difference between pi and ni corresponds to the initial voltage of the charging and discharging profile M, and the potential difference between pf and nf corresponds to the final voltage of the charging and discharging profile M.

According to an embodiment, the positive electrode (negative electrode) profile of the target battery may also be obtained by changing the ratio of pi, pf, ni, nf, and the adjusted positive electrode (negative electrode) profile after setting the capacity in advance.

When the negative electrode profile Rn of each target battery is generated or acquired through the above method, the characteristic information generating unit 140 generates, for each of the plurality of batteries, a change rate of the negative electrode profile Rn, specifically, a change rate of the negative electrode profile Rn compared to the reference negative electrode profile (hereinafter referred to as 'negative electrode change ratio (ns)') (S230). FIG. 7 is a drawing explaining a negative electrode change ratio (ns) generated based on a negative electrode profile. Specifically, the characteristic information generating unit 140 may be configured to calculate the ratio of the negative electrode profile to the reference negative electrode profile as the negative electrode change ratio.

For example, in the embodiment of FIG. 1, the characteristic information generating unit 140 generates k negative electrode change ratios (ns).

The negative electrode change ratio (ns) is an indicator representing the degree of degradation of the battery. As the degree of degradation increases, its size decreases. Therefore, the size of the negative electrode change ratio (ns) itself may be a key parameter for diagnosing the degree of degradation of the battery.

As described above, batteries applied to application devices (electric vehicles, ESS, etc.) are generally formed in the form where a plurality of batteries 10 are grouped as exemplified in FIG. 1. If there is a large deviation in the degree of degradation among the grouped batteries, collective performance degradation may occur in which the overall performance of the grouped batteries is degraded to the level of the battery with the highest degree of degradation (i.e., the most severe performance degradation).

In this respect, it is desirable to configure a defective battery BB to be selected based on the relative difference in degradation degree among the plurality of batteries 10, so the calculation processing unit 150 is configured to calculate the relative difference in the plurality of negative electrode change ratios (ns) (S240).

As a method for calculating the relative difference, a method for relatively comparing the negative electrode change ratio (ns) itself may be applied. Also, a method for calculating the difference between an average value of the plurality of negative electrode change ratios (ns) and an individual negative electrode change ratio (ns), or a method for functionally calculating a weight on the difference calculation result may be applied (S241). For example, the weight may be set in proportion to the size of the difference calculation result.

When this weight calculation is applied, it is possible to provide the advantage of more clearly distinguishing batteries whose negative electrode change ratio (ns) falls within the average value range and batteries whose negative electrode change ratio (ns) falls outside the average value range.

When the relative difference of the plurality of negative electrode change ratios (ns) is calculated in this way (S240), the diagnosing unit 160 diagnoses the state of the plurality of batteries 10 using the calculation result of the calculation processing unit 150 (S250).

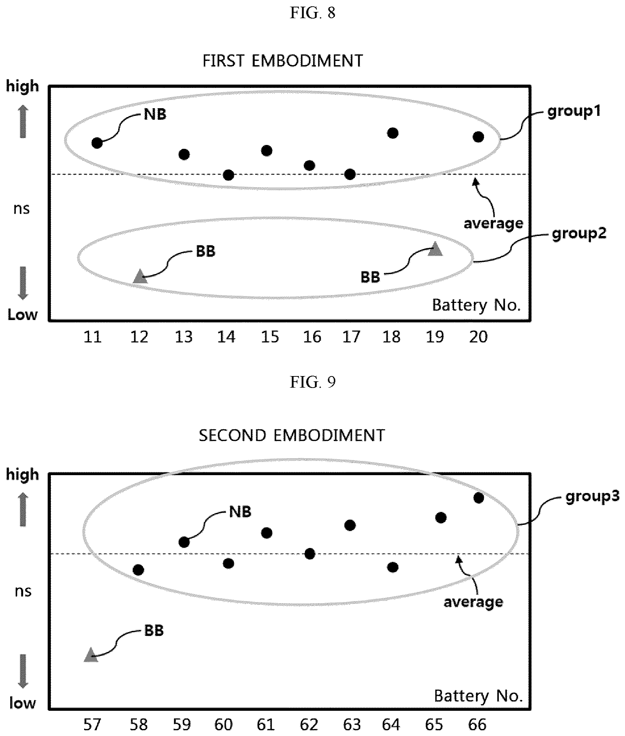

FIG. 8 is a drawing explaining a first embodiment of a negative electrode change ratio (ns) for each of a plurality of batteries. Specifically, FIG. 8 is a diagram illustrating the distribution of the negative electrode change ratios (ns) for 10 batteries with reference numbers 11 to 20 in the form of a graph.

In the embodiment of FIG. 8, since batteries with reference numbers 12 and 19 exhibit relatively low negative electrode change ratios (ns) compared to other batteries, the diagnosing unit 160 may diagnose these batteries (reference numbers 12 and 19) as defective batteries BB (S251). In addition, from a corresponding viewpoint, since the negative electrode change ratios (ns) of the remaining batteries form a distribution with a small deviation from the average value (average), the diagnosing unit 160 may diagnose the remaining batteries (reference numbers 11, 13-18, 20) as normal batteries NB (S251).

FIG. 9 is a drawing explaining a second embodiment of a negative electrode change ratio (ns) for each of a plurality of batteries. Specifically, FIG. 9 is a diagram illustrating the distribution of the negative electrode change ratios (ns) for 10 batteries with reference numbers from 57 to 66 in the form of a graph.

In the embodiment of FIG. 9, since the battery numbered 57 exhibits a relatively low negative electrode change ratio (ns) compared to other batteries, the diagnosing unit 160 may diagnose this battery (reference number 57) as a defective battery BB (S251). In addition, from a corresponding viewpoint, since the negative electrode change ratios (ns) of the remaining batteries form a distribution with a small deviation from the average value (average), the diagnosing unit 160 may diagnose the remaining batteries (reference numbers 58-66) as normal batteries NB (S251).

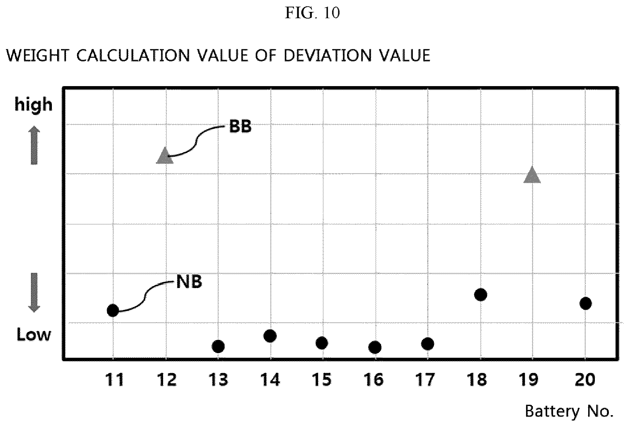

FIG. 10 is a drawing explaining an example of a distribution of deviation values generated using a negative electrode change ratio (ns). Specifically, FIG. 10 is a diagram illustrating the result of performing weight calculation (square of difference calculation result value) on the difference calculation result between the average value of the plurality of negative electrode change ratios (ns) and individual negative electrode change ratios (ns) based on the negative electrode change ratios (ns) of the plurality of batteries illustrated in FIG. 8.

When a weight calculation such as the square of the deviation value (the difference between the average value of the negative electrode change ratios (ns) and the individual negative electrode change ratios) or an exponential function (e.g., f(x) = 2^{x}, where x is the deviation value (absolute value)) is performed, as shown in FIG. 10, the value of the defective battery BB may be more clearly expressed in contrast to the value of the normal battery NB, so that the resolution for distinguishing the defective battery BB may be implemented more precisely.

When a defective battery BB is diagnosed by the diagnosing unit 160 of the present disclosure in this way, the management control unit 170 of the present disclosure may exclude the defective battery BB from the charging and discharging processing or control the charging and discharging of the defective battery BB to be limited to a specific range (S260).

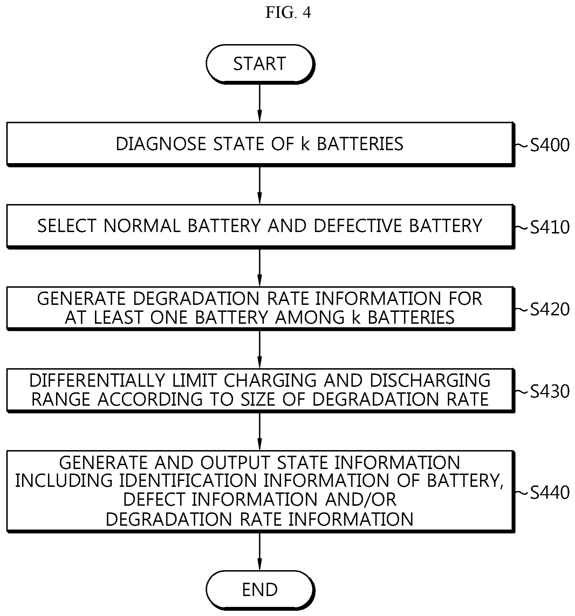

FIG. 4 is a flow chart illustrating a processing process according to another embodiment of the present disclosure.

As described above, when the current state of a plurality of batteries is diagnosed (S400) and a normal battery NB and a defective battery BB are selected accordingly (S410), the diagnosing unit 160 may be configured to generate degradation rate information of the defective battery BB by calculating a relative ratio of the negative electrode change ratio (ns) of the defective battery BB through a method of comparing it with a capacity value of a reference battery or the like (S420).

When the degradation rate information of a defective battery BB, etc. is generated in this way and input to the management control unit 170, the management control unit 170 may limit the charging and discharging range of the defective battery BB. Here, the management control unit 170 may control the charging and discharging range of the defective battery BB to be differentially limited according to the degradation rate information, such as by making the limitation of the charging and discharging range relatively large in the case of a defective battery BB having relatively large degradation rate information (S430).

According to an embodiment, the reference information storage unit 110 may be configured to further store identification information of the plurality of batteries 10 and/or attribute information including the identification information.

In this case, the information sharing unit 180 may be configured to generate state information including the identification information, defect information, or degradation rate information of the plurality of batteries 10 and output it to a user terminal or an info system of a vehicle (S440).

Furthermore, when the plurality of negative electrode change ratios (ns) of the plurality of batteries 10 are generated as described above, the calculation processing unit 150 may calculate the statistical deviation value (variance value, standard deviation value, etc.) of the plurality of negative electrode change ratios (ns).

Since the statistical deviation value is generated using the negative electrode change ratio (ns) of each of the plurality of batteries 10, this statistical deviation value becomes information representing the properties of a cell assembly (e.g., battery module, battery bank, or battery pack) referring to the plurality of batteries 10.

When a statistical deviation value is generated in this way, the diagnosing unit 160 may additionally diagnose the degradation imbalance of the plurality of batteries 10 using this statistical deviation value.

A relatively large statistical deviation value (compared to the reference value, etc.) means that there is a large deviation in the degradation of the plurality of batteries 10. In other words, it means that the degradation among the plurality of batteries 10 is not balanced or uniform. A relatively small statistical deviation value means that the degradation of the plurality of batteries 10 is uniform.

In this way, in the case of the present disclosure, the presence and degree of degradation imbalance of upper aggregates such as packs or modules are diagnosed, so subsequent processing or operations such as restricted use targeting packs or modules, exclusion of charging and discharging, and determination of replacement time may be more effectively induced.

In addition, the battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS.

The battery management apparatus 100 according to the present disclosure may be provided in a battery pack. That is, the battery pack according to the present disclosure may include the above-described battery management apparatus 100 and one or more batteries or the like.

Furthermore, the battery management apparatus 100 according to the present disclosure may be equipped in a vehicle such as an electric vehicle or a hybrid vehicle. That is, the vehicle according to the present disclosure may include the battery management apparatus according to the present disclosure or the battery pack according to the present disclosure. In addition, the vehicle according to the present disclosure may further include various other components included in the vehicle in addition to the battery management apparatus 100 or the battery pack. For example, the vehicle according to the present disclosure may further include a body, a motor, a control device such as an ECU (electronic control unit), etc. in addition to the apparatus according to the present disclosure.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

The attached drawings, etc. for the purpose of explaining the present disclosure and illustrating examples thereof may be illustrated in a somewhat exaggerated form in order to emphasize or highlight the technical content of the present disclosure. However, it should be interpreted that it is obvious that various modified application examples are possible at the level of a person skilled in the art by considering the previously described content and matters illustrated in the drawings.

In addition, it is self-evident that expressions such as first, second, upper, lower, or superior and inferior in the explanation of the present disclosure are merely instrumental concept terms used to relatively distinguish each component (element) from each other, and are not terms used to indicate a specific order, priority, etc., or terms used to physically distinguish each component (element) on an absolute basis.

### (Explanation of reference signs)

- 10:: plurality of batteries
- 100:: battery management apparatus
- 110:: reference information storage unit
- 120:: measuring unit
- 130:: profile generating unit
- 140:: characteristic information generating unit
- 150:: calculation processing unit
- 160:: diagnosing unit
- 170:: management control unit
- 180:: information sharing unit

## Claims

1. A battery management apparatus, comprising:
a reference information storage unit configured to store a reference profile including a reference negative electrode profile;
a profile generating unit configured to generate a negative electrode profile of each of a plurality of batteries using the reference profile and a charging and discharging profile of each of the plurality of batteries;
a characteristic information generating unit configured to generate a negative electrode change ratio of the negative electrode profile compared to the reference negative electrode profile for each of the plurality of batteries;
a calculation processing unit configured to calculate a relative difference of the plurality of negative electrode change ratios; and
a diagnosing unit configured to diagnose a state of the plurality of batteries using a calculation result of the calculation processing unit.

2. The battery management apparatus according to claim 1,
wherein the diagnosing unit is configured to diagnose a normal battery and a defective battery among the plurality of batteries using the calculation result.

3. The battery management apparatus according to claim 2, further comprising:
a management control unit configured to control charging and discharging of the defective battery to be limited.

4. The battery management apparatus according to claim 1,
wherein the diagnosing unit is configured to generate degradation rate information for at least one battery among the plurality of batteries using the calculation result, and
wherein the battery management apparatus further comprises a management control unit configured to control at least one battery among the plurality of batteries so that charging and discharging ranges are differentially limited according to the degradation rate information.

5. The battery management apparatus according to claim 1,
wherein the calculation processing unit is configured to perform weight calculation on a difference calculation result between an average value of the plurality of negative electrode change ratios and an individual negative electrode change ratio.

6. The battery management apparatus according to claim 1,
wherein the calculation processing unit is configured to calculate a statistical deviation value of the plurality of negative electrode change ratios, and
wherein the diagnosing unit is configured to further diagnose a degradation imbalance of the plurality of batteries using the statistical deviation value.

7. The battery management apparatus according to claim 1,
wherein the characteristic information generating unit is configured to calculate a ratio of the negative electrode profile to the reference negative electrode profile as the negative electrode change ratio.

8. A battery pack, comprising the battery management apparatus according to any one of claims 1 to 7.

9. A vehicle, comprising the battery management apparatus according to any one of claims 1 to 7.

10. A battery management method, comprising:
a profile generating step of generating a negative electrode profile of each of a plurality of batteries using a reference profile and a charging and discharging profile of each of the plurality of batteries;
a characteristic information generating step of generating a negative electrode change ratio of the negative electrode profile compared to a reference negative electrode profile included in the reference profile for each of the plurality of batteries;
a calculation processing step of calculating a relative difference of the plurality of negative electrode change ratios; and
a diagnosing step of diagnosing a state of the plurality of batteries using a calculation result of the calculation processing step.
